# EUROPÄISCHE PATENTANMELDUNG

(11) **EP 0 723 987 A2**
(43) Veröffentlichungstag der Anmeldung: **31.07.1996**
(21) Anmeldenummer: 96100597.2
(22) Anmeldetag: 17.01.1996
(51) Int. Cl.: C08J 7/06, C08L 49/00

(54) **Polyacetylenhaltige Formkörper**

(30) Priorität: 30.01.1995 DE 19502812
(71) Anmelder: BAYER AG, 51368 Leverkusen (DE)
(72) Erfinder: Ostoja Starzewski, Karl-Heinz A., Dr., D-61118 Bad Vilbel (DE); Thurm, Siegfried, Dr., D-40668 Meerbusch (DE)

(57) **Zusammenfassung**

Formkörper aus polyacetylenhaltigen Polymerprodukten aus Polyacetylen und einem von Polyacetylen verschiedenen Polymer zeichnen sich gegenüber Luft durch verbesserte Stabilität ihrer optischen und elektrischen Eigenschaften aus, wenn sie eine Schutzschicht aus SiOₓ, worin x beliebige Werte von 1 bis 2 annimmt, enthalten.

## Beschreibung

Die Erfindung betrifft polyacetylenhaltige Polymerprodukte, die sich durch verbesserte Stabilität gegenüber Luft und insbesondere Sauerstoff auszeichnen.

Polyacetylenhaltige Polymerprodukte sind aus US 4 769 422 bekannt. Sie eignen sich z.B. als elektrische Leiter und Halbleiter auf organischer Basis. Gegenüber reinem Polyacetylen lassen sie sich leicht zu Formkörpern, beispielsweise Folien oder Fasern verarbeiten. Sie sind stabiler als reines Polyacetylen. Bei erhöhter Temperatur sind sie jedoch empfindlich gegenüber Sauerstoff.

Ihre Herstellung ist z.B. in US 4 769 422 beschrieben. Dabei wird Acetylen in der organischen Lösung mindestens eines von Polyacetylen verschiedenen Polymeren und in Gegenwart bestimmter Nickel (O)-Komplexe polymerisiert. Das entstehende polyacetylenhaltige Polymerprodukt kann 0,1 bis 99 Gew.-%, vorzugsweise 1 bis 50 Gew.-% Polyacetylen enthalten.

Als von Polyacetylen verschiedenes Polymer kommen alle löslichen Polymere in Frage, z.B. Polystyrol, Polycarbonat, Polyvinylchlorid, Polychloropren, Polyether, Polyacrylnitril, Polyvinylpyrrolidon, Polyisopren, Polyvinylalkohol, Cellulose-Derivate, z.B. Methylcellulose und Mischpolymerisate wie Acrylnitril-Copolymere, Ethylen-Vinylalkohol-Copolymere, Butadien-Acrylnitril-Copolymere, die hydriert sein können, oder Acrylnitril(Meth)acrylat-Copolymere. Als Lösungsmittel werden die für die genannten Polymere geeigneten Lösungsmittel eingesetzt.

Bevorzugt sind Polymere mit polaren Gruppen und solche enthaltende Copolymere, beispielsweise Halogenatomen, Nitrilgruppen, Hydroxylgruppen, Acetylgruppen oder Carbonestergruppen, z.B. Polyvinylchlorid, Polyvinylalkohol, Polyvinylbutyral, Polyacrylnitril, Polyvinylpyrrolidon, Polyvinylcarbazol und Methylcellulose. Als Beispiel für ein Copolymer sei Styrol-Acrylnitril-Copolymer (SAN) genannt.

Als Lösungsmittel werden vorzugsweise polare aprotische Substanzen gewählt, z.B. Dimethylformamid und Dimethylsulfoxid.

Die polyacetylenhaltigen Polymerprodukte zeigen makroskopisch entweder eine heterogene oder eine homogene Polyacetylenverteilung in der Polymermatrix. Die heterogene Verteilung äußert sich durch diskrete schwarze Teilchen von Polyacetylen in der Polymermatrix, allerdings in hochdisperser Verteilung. Die homogene Verteilung äußert sich durch eine durchgehend gelb-braune, rote bis tiefblaue Färbung des Polymerproduktes.

Alle polyacetylenhaltigen Polymerprodukte lassen sich ohne Verlust ihrer optischen und elektrischen Eigenschaften in üblicher Weise zu Formkörpern, beispielsweise Fäden oder Platten verarbeiten.

Die elektrischen Eigenschaften ändern sich bei längerer Lagerung nicht.

Das Polyacetylen kann in üblicher Weise, beispielsweise mit Iod, dotiert werden. Durch die Dotierung läßt sich die elektrische Leitfähigkeit nach Bedarf etwa bis zu zehn Zehnerpotenzen steigern, wodurch die Produkte für einen weiten Anwendungsbereich vom Nichtleiter über den Halbleiter bis zum elektrischen Leiter einsetzbar werden. Der formale Dotierungsgrad ergibt sich aus der Gewichtszunahme durch die Iodierung.

Eine weitere Anwendung der polyacetylenhaltigen Polymerprodukte besteht in der Abschirmung empfindlicher elektrischer und elektronischer Bauteile vor elektromagnetischen Feldern, wozu beispielsweise ebene oder gewölbte Polymerplatten als Formkörper eingesetzt werden.

Erfindungsgemäß werden die Formkörper der polyacetylenhaltigen Polymerprodukte mit einer SiOₓ-Schicht versehen. Dies geschieht insbesondere dadurch, daß die genannten Formkörper durch Physical Vapor Deposition (PVD), durch Plasma-Chemical Vapor Deposition (Plasma-CVD) oder durch Sputtering mit dieser SiOₓ-Schutzschicht ausgerüstet werden. Diese Verfahren und ihre Ausführungsvarianten sind dem Fachmann bekannt. Dabei führen schon extrem dünne Schichten zu einer hervorragenden Stabilisierung des Polyacetylens gegenüber Sauerstoff, z.B. Schichten von 10 nm bis 10 µm, vorzugsweise 100 nm bis 1 µm.

Bei der Ausrüstung durch PVD wird marktgängiges SiO in Abwesenheit oder Anwesenheit verschiedener O₂-Mengen verdampft und auf dem auszurüstenden polyacetylenhaltigen Polymerprodukt niedergeschlagen. Bei Abwesenheit von O₂ erhält man eine SiO-Schutzschicht, bei Anwesenheit von O₂ steigt der Sauerstoffgehalt der Schutzschicht, bis schließlich bei überschüssigem O₂ eine Schicht von SiO₂ abgeschieden wird. SiOₓ mit beliebigen Werten von 1 bis 2 für x bezeichnet diesen Bereich. Für die Zwecke der Stabilisierung des Polyacetylens gegenüber Sauerstoff sind Werte von 1,1 bis 1,9, besonders von 1,4 bis 1,8 bevorzugt. Jedoch sind Werte bis zu x = 2 zur Erreichung mechanischer Eigenschaften (z.B. Kratzfestigkeit) wertvoll.

In analoger Weise kann die Ausrüstung mit Hilfe der Plasma-CVD erreicht werden, wobei man SiOₓ-Schutzschichten durch eine chemische Reaktion, beispielsweise eines Silans mit einer O₂-Quelle, wie N₂O oder anderen Stickstoffoxiden, und Niederschlagung auf dem auszurüstenden Formkörper erhält.

In einer Variante kann in zeitlicher Aufeinanderfolge die Schutzschicht zunächst aus sauerstoffärmerem SiOₓ mit x = 1,1 bis 1,8 und dann aus sauerstoffreicherem SiOₓ mit x = 1,4 bis 2 aufgebaut werden.

Zur weiteren Stabilisierung können auch Schnittkanten in der dargestellten Weise versiegelt werden.

Der stabilisierende Effekt der SiOₓ-Beschichtung läßt sich in einem Wärmetest, der an der Luft durchgeführt wird, nachweisen.

Zu diesem Zweck werden dünne transparente Schichten von Matrixpolyacetylenen erzeugt und deren Absorptionsspektren vor und nach der thermischen Belastung gemessen.

Zusätzliche Schutzschichten sind denkbar und könnten mit organischen Klebern oder mittels Silikaten fixiert werden. Diese könnten u.a. eine mechanische Beschädigung der dünnen SiOₓ-Schicht verhindern, oder auch als zusätzliche Sperrschicht wirken, wie etwa in Form einer PVDC-Lackierung.

### Beispiele

### Beispiel 1 (PVPPAC)

In einem ausgeheizten 250 ml 4-Halskolben, der mit Innenthermometer, Argon- und Acetylengaszuführung und Überdruckventil ausgestattet war, wurden unter Argon-Schutzgasatmosphäre 5 g Polyvinylpyrrolidon (PVP) in 95 g trockenem Dimethylformamid (DMF) während 30 Minuten bei ca. 60°C unter magnetischer Rührung gelöst. Bei 60°C wurden dann 0,5 mmol Katalysator [NiPh(Ph₂PCHCPhO)(i-Pr₃PCHPh)], gelöst in 3 ml DMF, injiziert und 1 Minute eingerührt (Ph = Phenyl; i-Pr = Isopropyl). Anschließend wurde in schnellem Strom 30 Sekunden Acetylengas durch die Lösung geleitet, welche sich blauschwarz färbte. Unumgesetztes Acetylen wurde durch einen starken Argonstrom verdrängt.

Die PVPPAC-Lösung wurde mit DMF im Verhältnis 1:1 verdünnt. Durch senkrechtes Eintauchen in diese Lösung und Trocknen an der Luft wurden Glasplatten beschichtet und die Lichtabsorption im sichtbaren Wellenlängenbereich gemessen. Weitere Messungen wurden nach thermischer Belastung auf 90°C an der Luft durchgeführt. Dabei fällt die Extinktion, und das Absorptionsmaximum verschiebt sich zu kürzerer Wellenlänge. Die Farbe der klaren Lackschicht verändert sich von blau nach rötlich.

| t (90°C) | Eₘₐₓ | λₘₐₓ |
|---|---|---|
| 0 min | 2,83 | 642 nm |
| 60 min | 2,36 | 588 nm |
| 120 min | 2,09 | 562 nm |

### Beispiel 2

Ein Probenstück einer mit PVPPAC beschichteten Platte nach Beispiel 1 der Abmessung 60 mm x 60 mm wurde in einer Aufdampfanlage A 1100 der Fa. Leybold-Heraeus, Hanau, BRD, auf einem rotierbaren Substrathalter befestigt. Anschließend wurde die Prozeßkammer der Aufdampfanlage geschlossen und auf ca. 10⁻³ Pa evakuiert. Danach wurde O₂ bis zu einem Druck von 7 Pa eingelassen und der Drehantrieb des Substrathalters eingeschaltet, so daß dieser mit 20 U/min rotierte. Durch Anlegen einer Spannung von -480 V gegen Erde an eine als Kathode geschaltete Al-Platte wurde ein Niederdruckplasma gezündet. In diesem Plasma wurden die Proben zwei Minuten mit einer Leistung von 5,6 Watt behandelt. Danach wurde die Spannung abgeschaltet, die O₂-Zugabe beendet und die Prozeßkammer auf 10⁻⁴ Pa evakuiert.

Nach Erreichen dieses Druckes wurde erneut O₂ in die Prozeßkammer eingeleitet, bis sich ein Druck von 10⁻² Pa einstellte. Nach Erreichen dieses Druckes wurde die Elektronenstrahlkanone eingeschaltet und das zu verdampfende SiO (Handelsname Patinal, Fa. Merck, Darmstadt), welches sich in einem wassergekühlten Cu-Tiegel befand, mit einer Leistung von 400 W innerhalb von vier Minuten auf ca. 1950 K erhitzt. Anschließend wurde eine bewegliche Blende zwischen Elektronenstrahlkanone und Substrathalter entfernt und die Folienstücke für 400 sec mit einer Rate von 0,5 nm/sec beschichtet. Danach wurde die Blende wieder zwischen Elektronenstrahlkanone und Substrathalter eingebracht, die O₂-Zugabe abgestellt und der Beschichtungsvorgang beendet. Nach dem Abschalten der Elektronenstrahlkanone und der Abkühlung des Verdampfungsgutes wurde die Prozeßkammer belüftet, die einseitig SiOₓ-beschichtete Platte entnommen, gewendet und wie vorstehend beschrieben auf der noch unbeschichteten Seite bedampft.

Eine so behandelte Platte änderte im Wärmetest (gemäß Beispiel 1) weder Farbe (blau) noch Absorption.

## Patentansprüche

1. Formkörper aus polyacetylenhaltigen Polymerprodukten aus Polyacetylen und einem von Polyacetylen verschiedenen Polymer, dadurch gekennzeichnet, daß sie eine Schutzschicht aus SiOₓ, worin x beliebige Werte von 1 bis 2, bevorzugt von 1,1 bis 1,9, besonders bevorzugt von 1,4 bis 1,8 annimmt, enthalten.

2. Formkörper nach Patentanspruch 1, dadurch gekennzeichnet, daß das Polyacetylen 0,1 bis 99 Gew.-% der Summe aus Polyacetylen und von Polyacetylen verschiedenem Polymer ausmacht.

3. Formkörper nach Patentanspruch 1, dadurch gekennzeichnet, daß das Polyacetylen 1 bis 50 Gew.-% der Summe aus Polyacetylen und von Polyacetylen verschiedenem Polymer ausmacht.

4. Formkörper nach Anspruch 1, dadurch gekennzeichnet, daß das von Polyacetylen verschiedene Polymer polare Gruppen enthält.

5. Formkörper nach Patentanspruch 1, dadurch gekennzeichnet, daß die Schutzschicht aus SiOₓ durch Physical Vapor Deposition (PVD), durch Plasma-Chemical Vapor Deposition (Plasma-CVD) oder durch Sputtering erzeugt wird.

6. Formkörper nach Patentanspruch 1, dadurch gekennzeichnet, daß die SiOₓ-Schutzschicht eine Dicke von 10 nm bis 10 µm, bevorzugt 100 nm bis 1 µm hat.
